# EUROPEAN PATENT APPLICATION

(11) **EP 4 346 339 A1**
(43) Date of publication of application: **03.04.2024**
(21) Application number: 22199193.8
(22) Date of filing: 30.09.2022
(51) Int. Cl.: H05K 1/09, H05K 3/20, H05K 1/02, H05K 3/12

(54) **METHOD AND DEVICE FOR PRINTING A SUBSTANCE ON A TARGET SURFACE OF A TARGET**

(71) Applicant: Nederlandse Organisatie voor toegepast-natuurwetenschappelijk Onderzoek TNO, 2595 DA 's-Gravenhage (NL)
(72) Inventor: HENDRIKS, Rob Jacob, 2595 DA 's-Gravenhage (NL); KOLDEWEIJ, Robin Bernardus Johannes, 2595 DA 's-Gravenhage (NL); BETSEMA, Ruben, 2595 DA 's-Gravenhage (NL)
(74) Representative: V.O.

(57) **Abstract**

A printing device (1) is provided herein for printing a substance on a target surface (TS) of a target (T). The printing device comprises a carrier (2) having at a first main side (21) a carrier surface (2s) for carrying a specimen (SB1, SB2, SB3) of the substance to be printed. The printing device further comprises a heater facility (23) for heating the carrier surface to vaporize a portion of the specimen at the side of the carrier surface and inducing a vapor pressure that causes a transfer of a remainder of said specimen towards the target surface and a structured thermal buffer layer (25) that provides for a position dependent delay with which heat is transferred from the heater facility to the carrier surface.

## Description

The present application pertains to a device for printing a substance on a target surface of a target.

The present application further pertains to a method for printing a substance on a target surface of a target.

International patent application WO2021230746 discloses a transfer method to transfer a substance formed by a viscous functional material onto a receiving substrate, where the deposited substance is subsequently cured or dried. The cured or dried substance transferred to the target may serve as an electrical insulator, an electrical conductor, a thermal insulator, a thermal conductor and the like.

The known method comprises heating the substance to vaporize an interface layer of a specimen of the substance at the side of the plate in order to induce a vapor pressure between the substance and the plate. The vapor pressure exerts a force on the substance that serves to eject the remaining, non-vaporized, portion of the substance away from the plate in order to cause its transfer from the plate to a target surface.

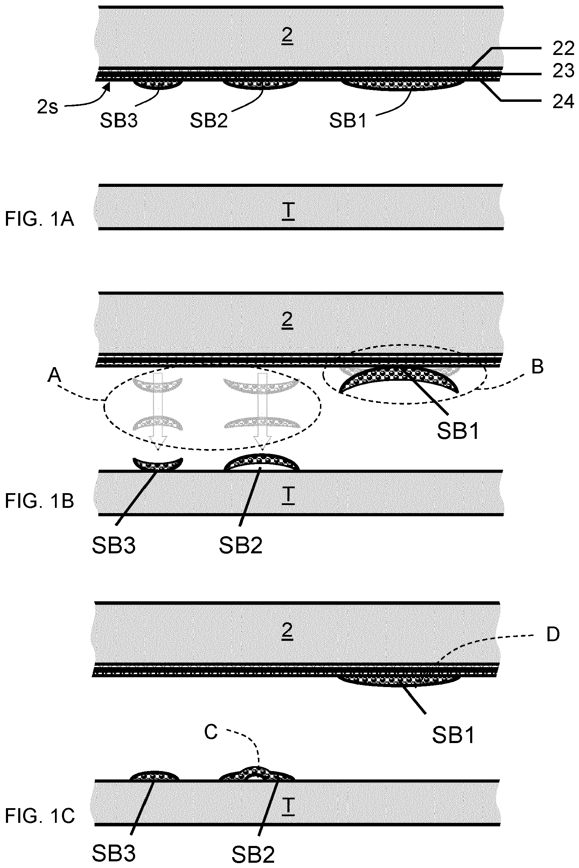

It was found by the inventor that occasionally transfer of the heated substance may hamper in case specimen of different sizes have to be transferred. In FIG. 1A to 1C, the inventor identified various underlying causes. Therein FIG. 1A shows an initial state wherein the specimen SB1, SB2, SB3 of mutually different sizes are arranged at a surface of carrier 2 facing the target T. As illustrated in FIG. 1B the inventor noted that the due to local differences in the pressure induced between the carrier and a specimen, the specimen is deformed and starts vibrating (A,B) upon initiating a transfer. The amplitude and frequency of these vibrations depends on the material properties of the substance but also on the dimensions of the specimen. Accordingly, as shown in FIG. 1B, even if specimen of a same substance are to be transferred these vibrations may affect the transfer process in a mutually different way. In this example the smallest specimen SB3 arrives at the surface of the target T while it is in a convex shape as seen from the target. This is the preferred situation as after the vibration is damped (See FIG. 1C) the specimen SB3 fully covers the target surface. However, the larger specimen SB2 arrives at the surface of the target T while it is in a concave shape as seen from the target. In this case the specimen SB2 does not properly cover the substrate surface. As can be seen in FIG. 1C, after landing on its rim, the specimen SB2 adheres to the target T and encloses an air bubble C. The vibration causes a different phenomenon for the largest one SB1 of the specimen. In this example the specimen SB1 oscillates one time and its center retouches B the heater while it's cold again (below evaporation temperature). As shown in FIG. 1C, In this case the specimen stays D on the carrier 2 and is not transferred at all.

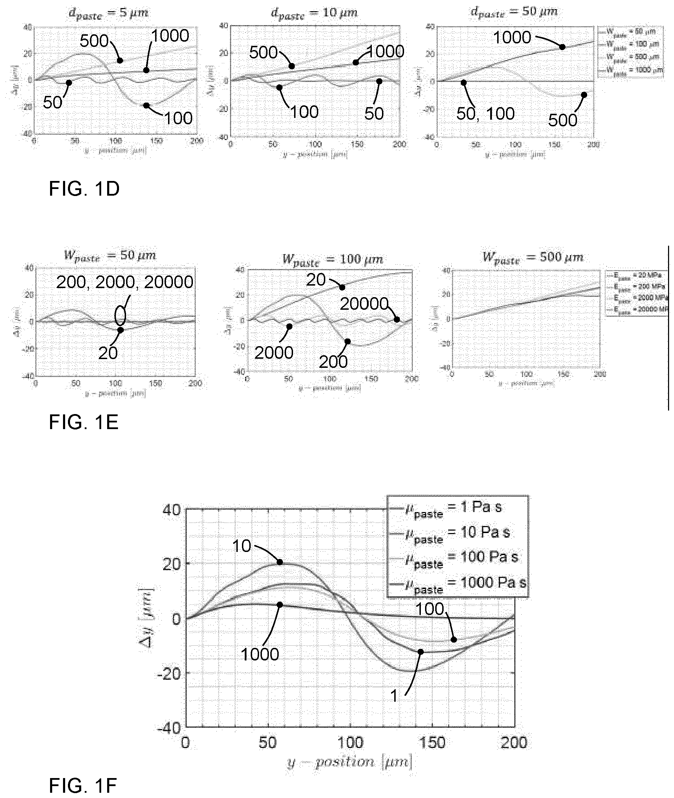

FIG. 1D, 1E and 1F provided simulation results based on a 2D temperature to pressure model that indicates the effect of various parameters on the printing process.

FIG. 1D shows oscillations occurring in a specimen of substance during its transfer from the carrier 2 to the surface TS of the target dependent on the dimensions of the specimen. The simulations were performed with the following parameters:
Heat flux 150 kW/cm2
Modulus of elasticity of the substance E = 200 MPa
Viscosity of the substance η = 10 Pa.s

In an order from left to right the graphs in FIG. 1D show simulations wherein the thickness of the specimen is 5 µm, 10 µm, and 50µm. In these graphs the horizontal axis indicates the center distance y from the specimen to the printing plate. The vertical axis Δy indicates the amount with which distance y from the specimen to the printing plate deviates at the edge of the specimen due to oscillations occurring therein. When the value of Δy is positive, the pancake shaped specimen bends outwards (with respect to the plate), and when it's negative, it is curved in the other direction. The relationship is shown for four values of the viscosity: 1 Pa.s, 10 Pa.s, 100 Pa.s and 1000 Pa.s.

For example, when printing a 5 micron thick, 100 micron wide film (AR = 0.05), then it would impact in a concave shape at a print gap of around 150 µm (-20 µm, see graph). This would mean that air would get entrapped. The elastic modulus mainly affects the oscillation frequency, while the viscosity has a stronger effect on the amplitude.

FIG. 1E shows a second set of simulations. In an order from left to right the graphs in FIG. 1E show simulations wherein the width of the specimen is 50 µm, 100 µm, and 500µm. Also in this case the value chosen for the heatflux is 150 kW/cm2 and the viscosity of the substance η = 10 Pa.s. The modulus of elasticity of the substance is varied in the range from 20 to 20000 MPa. The value is indicated in the graphs in MPa.

FIG. 1F shows a further example wherein transfer is simulated of a specimen with a thickness of 5 micron and a diameter of 100 micron for various values of the viscosity. These viscosity values are indicated in Pa.s.

Provided that specimen having the same size and being of a same specimen are printed, a proper transfer to the target T can be achieved by a suitable choice of the power supplied to the heat source for inducing the transfer.

In practice, there is however a need for properly transferring specimen of a mutually different size and/or of a different composition.

### SUMMARY

According to a first aspect of the present disclosure, in order to address the above-mentioned need an improved device is provided for printing a substance on a target surface of a target.

According to a second aspect of the present disclosure, in order to address the above-mentioned need an improved method is provided for printing a substance on a target surface of a target.

Embodiments of the improved printing device comprise a carrier having at a first main side a carrier surface for carrying a specimen of the substance to be printed, and a heater facility for heating the carrier surface to vaporize a portion of the specimen at the side of the carrier surface and inducing a vapor pressure that causes a transfer of a remainder of said specimen towards the target surface. The improved printing device further comprises a structured thermal buffer layer that provides for a position dependent delay with which heat is transferred from the heater facility to the carrier surface.

The structured thermal buffer layer controls the heat flux, and therewith the release time. The structured thermal buffer layer can be continuous later having thickness variations, but may also be locally absent, i.e. having a thickness 0.

It has been found that a relatively thin thermal insulating layer, for example a layer of a ceramic material like SiO2, the heat flux, and therefore the release time, can be controlled to enable a proper transfer of specimen of mutually different sizes and/or of a different compositions.

In some embodiments the heater facility is an electric heater layer for resistively heating the carrier surface. This is advantageous, in that an electric heater layer can be accommodated in the carrier and therewith requires a minimum amount of space. Alternatively, if there are no space limitations, the heater facility may be provided as a photon radiation source. In the latter case the carrier may be provided with a photon radiation absorbing layer, wherein the structured thermal buffer layer provides for a position dependent delay with which heat induced by absorption of radiation from the photon radiation source is transferred to the specimen.

In some embodiments the carrier surface comprises at least a first specimen carrier area and a second specimen carrier area for respectively carrying a first and a second specimen of the substance to be printed wherein a thickness of the thermal buffer layer within the one of the at least a first specimen carrier area and a second specimen carrier area having the largest size is greater than a thickness of the thermal buffer layer within the one of the at least a first specimen carrier area and a second specimen carrier area having the smallest size. The structured thermal buffer layer locally lowers the heat flux and control the vibrational frequency of every specimen. By bringing all frequencies closer to each other and control the printing gap, it becomes possible to increase the processing window and land various droplet sizes without air entrapment.

Changing the heat flux at the substrate surface only requires a thin layer of silicon dioxide (or any other low CTE material with a low thermal conductivity). For SiO2 the effective layer thickness is in the range of 10 - 1000 nm when using heat fluxes in the order of 50 - 250 kW/cm2. The heat flux also changes the transfer velocity of the ink film, which directly influences the landing shape at a given print gap. As a general rule of thumb larger specimen require a locally larger thickness of the structured thermal buffer layer.

In some embodiments the device has a specimen carrier area configured for carrying a specimen of the substance to be transferred to a target, the structured thermal buffer layer has a thickness profile within the specimen carrier area to control a dynamic behavior of the remainder of the specimen during its transfer to the target surface.

As a result of the thickness profile of the thermal buffer layer within the specimen carrier area, the thermal buffer layer causes a position dependent delay with which heat from the heater facility is transferred to the surface within the specimen carrier area. As noted, the structured thermal buffer layer having a varying thickness includes the special case wherein regions of the structured thermal buffer layer have a thickness of 0 and other regions have a predetermined thickness. In that special case, the regions of the structured thermal buffer layer having a thickness different from zero, e.g. a predetermined thickness value provide for a delay with which heat is transferred from the heater facility to the specimen as compared to the regions of the structured thermal buffer layer where the thickness is zero. Therewith a pressure distribution as a function of time as a result of evaporating specimen is controlled. At locations where the thermal buffer layer is relatively thick, the heat flux is delayed more and reduced more in intensity than at locations where the thermal buffer layer is relatively thin or absent. Therewith a delay and speed with which the remainder of the specimen is transferred in different sections thereof is controlled. This also determines the dynamic behavior of the remainder of the specimen being transferred.

In an application the thickness profile of the thermal buffer layer within a specimen carrier area is used to control the dynamic behavior of the remainder of the specimen being transferred so as to optimize a coverage thereof on a non-planar surface of a target. For example, in case of a line shaped specimen a portion thereof in a region of the structured thermal buffer layer with a small or zero valued thickness is transferred earlier and with a smaller or no delay as compared to a portion thereof in a region of the structured thermal buffer layer with a higher valued thickness.

In another application the thickness profile of the thermal buffer layer within a specimen carrier area is used to control the dynamic behavior of the remainder of the specimen being transferred so as to control oscillations thereof during its transfer. In one example, the thermal buffer layer has a thickness that decreases in a radially outward direction from a central position of the specimen carrier area. Therewith oscillations can be suppressed. Therewith it is rendered possible to select the print gap from a large range while avoiding the risk of bubble entrapment. Alternatively, the thickness profile of the thermal buffer layer can be provided to induce a particular oscillation, for example to achieve that the remainder of the specimen is deposited in a predetermined pattern.

In an example of this application the specimen carrier area has a first portion to be positioned opposite a surface portion of the target that is relatively close to the carrier, a second portion to be positioned opposite a surface portion of the target that is relatively far from the carrier and laterally near the surface portion of the target and a third portion to be positioned opposite a surface portion of the target that is relatively far from the carrier and laterally more remote from the surface portion of the target, and wherein a thickness of the structured thermal buffer layer in the second portion is smaller than a thickness of the structured thermal buffer layer in the first portion and the third portion or is absent. Therewith it is achieved that the specimen is transferred with a velocity profile along its length with which it deposited in a manner conformal with the target surface.

It is noted that thermal buffer layer may be provided with a superposition of a first structure that serves to locally control a vibration frequency and a second structure that serves to locally control a speed of transfer of a specimen.

In some embodiments the carrier is provided at the first main side with at least one recess for accommodating a specimen of the substance to be printed and a thickness of the structured thermal buffer layer near a boundary of the recess is smaller than a thickness of the structured thermal buffer layer in a central portion of the recess. In these embodiments the improved printing device is particularly suitable for a controlled transfer of highly viscous substances from recesses. For highly viscous substances inks it is important to avoid shear. Hence there should be no or limited difference in a delay with which the substance in the recess is heated. This delay time is preferably below 1 microsecond, otherwise the substance will experience significant shear forces resulting in severe deformation and even cause the substance to break up and splash or prevent the substance from being transferred towards the acceptor substrate. The presence of a structured thermal buffer layer in the bottom of the recess locally reduces the heat flux and therewith delays the release. By tuning the thickness of the thermal buffer layer it becomes possible to release the substance (near) simultaneously, which significantly improves the print quality and even enables printing of even smaller microstructures. Although it's possible to release the substance from the side walls first, it is preferred to release the sides with a slight delay (0.1 - 0.5 µs). This will deform the substance into a convex shape, which helps preventing bubble entrapment when impacting the acceptor substrate.

In a still further embodiment, the structured thermal buffer layer of the improved printing device is provided within at least one specimen carrier area with a plurality of microwells, wherein a specimen of the substance to be printed on is distributed over said microwells. In contrast to (near) shearless printing of highly viscous fluids, low viscosity substances can actually benefit from shear forces to form microjets. In order to create microjets, microwells (<50 µm) are etched in a thermal buffer layer (SiO2) without adding a heat spreader structure inside the wells. When applying the heat pulse, a vapor bubble will only be formed in the bottom of the microwell. Because the substance has a low viscosity (< 1 Pa*s), there is enough pressure to deform the liquid into a jet. Upon impact with the acceptor substrate the substance can spread and flow together to form a uniform coating. The microwells may have a mutually different depth or may have a same depth. A time of release and ink volume can be controlled with the depth of the microwells.

In some embodiments of the improved printing device the structured thermal buffer layer is provided within at least one specimen carrier area with a plurality of micropillars. These embodiments of the improved printing device are particularly suitable for printing solder pastes comprising relatively large metal particles with a relatively high thermal conductivity as compared to the medium wherein they are embedded. Should such a metal particle come in close proximity (<2 µm) of the heater, it will act as a strong heat sink. This causes the temperature to rise slower near the metal particles, which results in a delayed release. If heat sinking is asymmetrical, then the ink/paste would not transfer perpendicular to the heater plate and land on the wrong location on the acceptor substrate. In these embodiments of the improved printing device the presence of the micropillars prevents a direct contact of the micro particles with the heated surface, therewith avoiding that heat sinking occurs.

Embodiments of the improved method for printing a substance on a target surface of a target comprise:
providing a carrier having at a first main side a carrier surface for carrying a specimen of the substance to be printed;
providing a heater facility for heating the carrier surface;
providing a structured thermal buffer layer between the resistive heater layer and the carrier surface;
activating the heater facility;
with the structured thermal buffer layer transferring heat from the heater facility with a position dependent delay to the carrier surface;
wherein heat transferred to the carrier surface causes a portion of the specimen in contact with the carrier surface to vaporize with the position dependent delay determined by the structured thermal buffer layer and therewith inducing a vapor pressure that causes a transfer of a remainder of said specimen towards the target surface.

A first exemplary embodiment comprises providing the carrier surface with at least a first specimen carrier area and a second specimen carrier area for respectively carrying a first and a second specimen of the substance to be printed, and providing the thermal buffer layer with a thickness within the one of the at least a first specimen carrier area and a second specimen carrier area having the largest size that is greater than a thickness of the thermal buffer layer within the one of the at least a first specimen carrier area and a second specimen carrier area having the smallest size.

A second exemplary embodiment comprises providing the structured thermal buffer layer with a varying thickness to provide for a position dependent delay with which the specimen is transferred to the target to optimize a coverage of the deposited specimen of the substance on a non-planar surface of the target.

A third exemplary embodiment comprises providing the carrier at the first main side with at least one recess for accommodating a specimen of the substance to be printed and providing the structured thermal buffer layer with a thickness near a boundary of the recess that is smaller than a thickness of the structured thermal buffer layer in a central portion of the recess.

A fourth exemplary embodiment comprises providing the structured thermal buffer layer within at least one specimen carrier area with a plurality of microwells, wherein a specimen of the substance to be printed is distributed over said microwells.

A fifth exemplary embodiment comprises providing the structured thermal buffer layer within at least one specimen carrier area with a plurality of micropillars.

### BRIEF DESCRIPTION OF THE DRAWINGS

These and other aspects are described in more detail with reference to the drawing. Therein:
FIG. 1A to 1C show phenomena occurring in operation of a prior art printing device used in a first application;
FIG. 1D to 1F show simulation results indicating a dynamic behavior of viscous substances relevant for the present application;
FIG. 2A to FIG. 2C shows operational stages of an embodiment of the improved printing device in the first application;
FIG. 3A to 3C show phenomena occurring in operation of a prior art printing device used in a second application;
FIG. 4A to 4C show operation of an embodiment of the improved printing device in the second application;
FIG. 5A to 5C show phenomena occurring in operation of a prior art printing device used in a third application;
FIG. 6A to 6C show operation of an embodiment of the improved printing device in the third application;
FIG. 6D and 6E show simulation results pertaining to the third application;
FIG. 7 shows phenomena occurring in operation of a prior art printing device used in a fourth application;
FIG. 8 shows operation of an embodiment of the improved printing device in the fourth application;
FIG. 9A and 9B illustrate aspects of a further embodiment of the improved printing device. Therein FIG. 9A shows the first main side of a lateral portion of the carrier 2, and FIG. 9B shows a cross-section according to IXB-IXB in FIG. 9A;
FIG. 10A to 10C show operation of said further embodiment of the improved printing device,
FIG. 11A - 11C show simulation results.

### DETAILED DESCRIPTION OF EMBODIMENTS

Like reference symbols in the various drawings indicate like elements unless otherwise indicated.

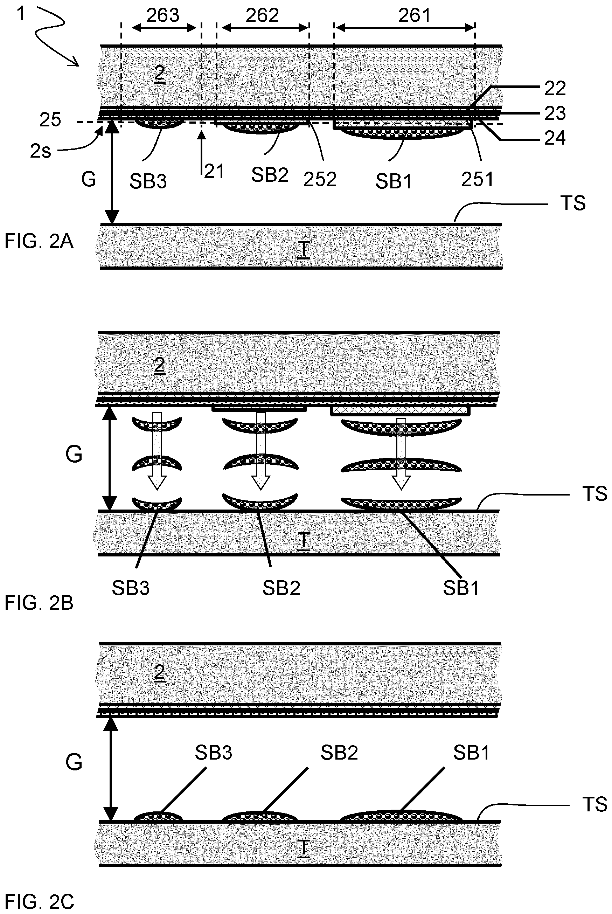

FIG. 2A-2C schematically shows operational stages of an embodiment of an improved printing device 1 for printing a substance on a target surface TS of a target T. The target is for example a rigid substrate for example made of a glass or a flexible substrate, for example made of a polymer. As shown in FIG. 2A, the printing device 1 comprises a carrier 2 that has at a first main side 21 a carrier surface for carrying a specimen of the substance to be printed. The substance can have predetermined physical features, such as a specific electric conductivity and a specific thermal conductivity. For example, the substance can be an electrically insulating and thermally insulating material, an electrically insulating and thermally conductive material, an electrically conductive and thermally insulating material, and an electrically conductive and thermally conductive material. The substances, commonly also denoted as inks or pastes for example comprise nanoparticle or microparticles or a mix thereof suspended in a (high boiling point) solvent. Also epoxy based materials, such as adhesives or conductive adhesives with silver micron particles are used. Alternatively or additionally the substance may comprise one or more of a positive or negative photoresist, a polymer solution, a molten polymer, a monomer or a silicone based material. For the purpose of the present invention it suffices that the substance comprises a component that can be evaporated at a relatively modest temperature, i.e. not higher than a few hundred degrees C.

In this case three specimen SB1, SB2, SB3 of the substance having mutually different sizes are present on the carrier surface.

The improved printer device comprises a heater facility. Upon activation the heater facility heats the carrier surface to therewith vaporize a portion of the specimen at the side of the carrier surface and to induce a vapor pressure that causes a transfer of a remainder of the specimen towards the target surface. In the example shown, the heater facility is an electric heater layer 23 for resistively heating the carrier surface.

In the figures illustrated herein a thermal insulating layer 22 is arranged between the carrier 2 and the resistive heater layer 23. This thermal insulating layer 22 layer is optional but mitigates a heat-loss in a direction away from the carrier surface, and therewith contributes to a more efficient operation. The thermal insulating layer 22 is for example provided of a ceramic material and for example has a thickness in the range of a few hundred nm to a few micron. The thermal insulating layer therewith also serves as an electrically insulating layer. In a process efficient way, the thermal insulating layer is obtained by oxidizing the material of the carrier 2. For example in case the carrier is provided as a silicon (1-0-0) wafer, a thermal insulating layer 22 of SiO2 can be obtained by oxidizing the carrier.

In an embodiment the figures further show an electrical insulating layer 24 that is arranged between the resistive heater layer 23 and the structured thermal buffer layer 25. Also in this case a layer of a ceramic material having a thickness in the of a few hundred nm to a few micron is suitable. In one example the material used for this layer is Si3Ni4. The electrical insulating layer 24 can be omitted in case the printer device is used only for depositing electrically insulating substances. Also the electrical insulating layer 24 may be omitted in case the structured thermal buffer layer 25 has a non-zero thickness in the areas provided to carry the substance to be printed.

As further shown in FIG. 2A, the improved printer device further comprises a structured thermal buffer layer 25 that provides for a position dependent delay with which heat is transferred from the heater facility 23 to the carrier surface.

In the embodiment shown in FIG. 2A the carrier surface comprises at least a first specimen carrier area 261 and a second specimen carrier area 262 for respectively carrying a first and a second specimen SB1, SB2 of the substance to be printed. The thermal buffer layer 25 has the largest thickness in the first specimen carrier area 261 which is provided to carry the largest specimen SB1. In the second specimen carrier area 262 that is provided to carry the one but largest specimen SB2 the thermal buffer layer 25 has a smaller thickness as compared to that in the first specimen carrier area 261. In a third specimen carrier area 263 that is provided to carry the smallest specimen SB3 the thickness of the thermal buffer layer 25 is zero.

FIG. 2B shows an operational stage wherein the resistive heater layer 23 has heated the carrier surface to vaporize a portion of the specimen at the side of the carrier surface and therewith induces a vapor pressure that causes a transfer of a remainder of said specimen towards the target surface. With the structured thermal buffer layer 25 it is achieved that heat from the resistive heater layer 23 is that transferred with a position dependent delay to the carrier surface in accordance with the size of the specimen to be printed. The delay is longer for the larger specimen. As a result, it is achieved that all specimen have a convex shape upon arriving at the target surface TS. As shown in FIG. 2C, therewith each of the specimen SB1, SB2, SB3 properly covers the target surface, and it is avoided that an air bubble is enclosed. Also, it is avoided that the oscillation causes the specimen to retouch the heater after initiation of the transfer towards the target. Whereas the same effect could be achieved with a heater facility that controllably supplies a heat flux dependent on the size of the specimen, this would involve considerable higher costs.

As an example experimental results were obtained wherein the substance to be printed was SunChemical silver micron flake ink, provided with a stencil thickness of 100 microns on the carrier surface. For printing, heat was provided with a fixed fluence of 0.5 J/cm2, and the maximum printable droplet diameter Dmax (µm) was determined as a function of the heat flux (kW/cm2) as shown in the following table.

| heat flux (kW/cm2) | Dmax (µm) |
|---|---|
| 100 | 1000 |
| 125 | 750 |
| 150 | 350 |

Hence, for example specimen having a diameter of 350 µm, 750 µm and 1000 µm can be printed with a same heater facility that provides a heating pulse fixed fluence of 0.5 J/cm2 and heat flux of 150 kW/cm2 provided that the structured thermal buffer layer 25 has a non-zero thickness at the location of the larger specimen sized 750 µm and 1000 µm to moderate the local heatflux to a maximum of 125 kW/cm2 and 100 kW/cm2 respectively. The structured thermal buffer layer 25 can have a zero-thickness at the location of the smallest specimen.

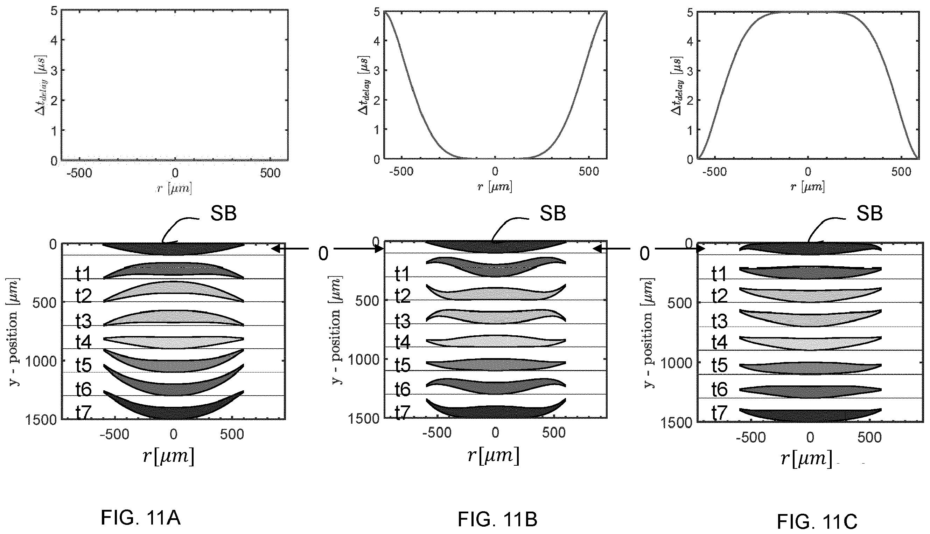

Simulation results shown in FIG. 11A - 11C further confirm that oscillations of the specimen being transferred can be substantially mitigated when the structured thermal buffer layer has a thickness that decreases in a radially outward direction from a central position of the specimen to be transferred.

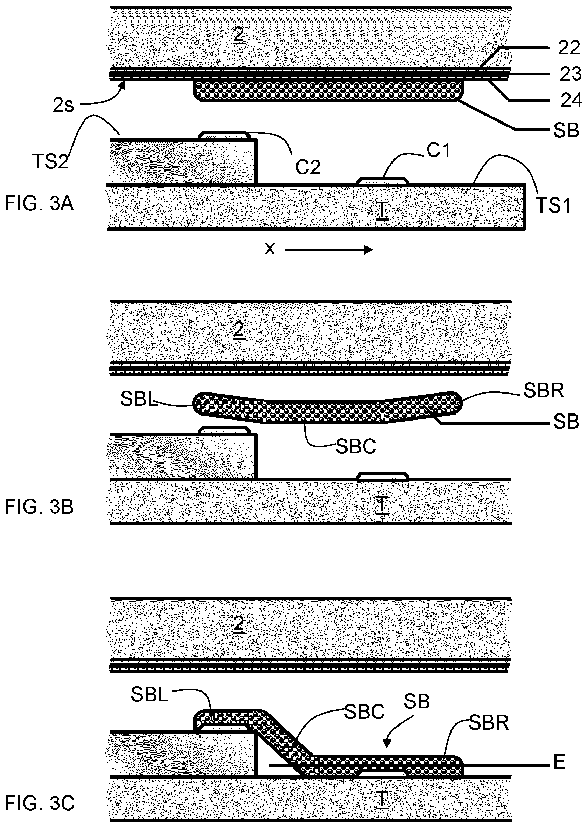

FIG. 3A, 3B, 3C show another application, performed with a conventional printing device. The application shown therein pertains to printing an elongate strip of a substance SB on a target T having a height profile in the direction where the strip is to be printed. In the example shown, the strip SB to be printed is of a conductive material that is to connect contacts C1, C2. The height profile is defined here by a first target surface portion TS1 where the contact C1 is arranged having a relatively large distance to the carrier 2 and a second target surface portion TS2 where the contact C2 is arranged.

FIG. 3B shows an operational stage wherein the resistive heater layer 23 has heated the carrier surface to vaporize a small layer of the specimen SB at the side of the carrier surface and therewith induces a vapor pressure that causes a transfer of a remainder of said specimen towards the target surface. As shown in FIG. 3B, the strip SB approximately moves forwards to the target T with a substantially constant velocity profile along its length. The velocity is only slightly lower at its ends SBL, SBR that in its center portion SBC, as the vapor pressure distribution is mainly determined by the distance to the side of the strip SB, which is substantially constant in the direction x if the width of the strip is substantially smaller than its length.

As a result, as shown in FIG. 3C, the side SBL will first reach the target at the second target surface portion TS2 which is elevated relative to the first target surface portion TS1. At that point in time the velocity of the central portion SBC of the strip will decrease, and as a result the side SBR of the strip SB will contact the first target surface portion TS1. Due to the cohesion of the substance of the specimen the central portion SBC will not cover the first target surface portion TS1 but leave an empty space E. This results in a fragile connection.

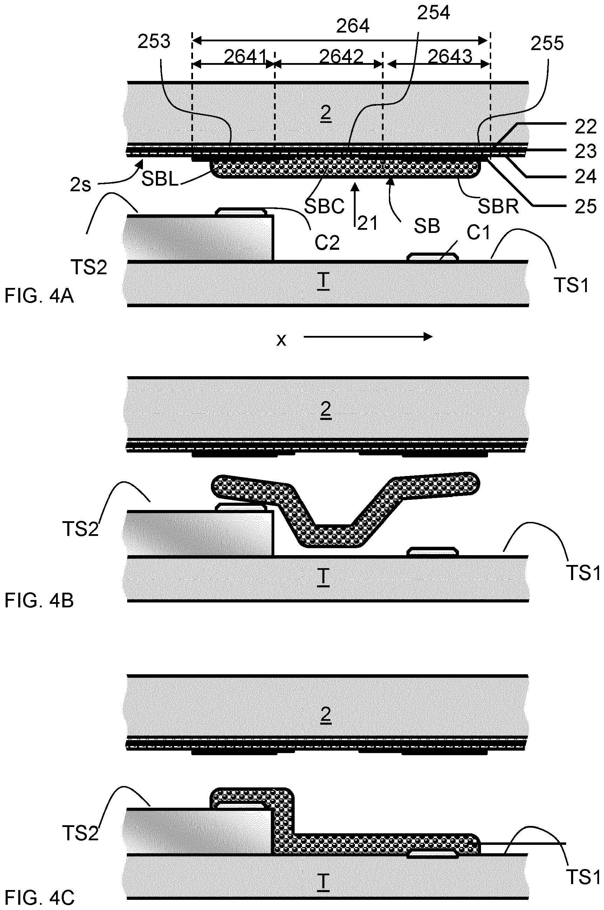

FIG. 4A, 4B, 4C show the same application as described with reference to FIG. 3A, 3B and 3C, now performed with an embodiment of the improved printing device.

The embodiment of the improved printing device shown in FIG. 4A has a specimen carrier area 264 configured for carrying a specimen SB of the substance to be transferred to a target T with a non-planar surface TS1, TS2. That is, the structured thermal buffer layer 25 has a varying thickness within the specimen carrier area 264. As the thickness of the thermal buffer layer 25 is a function of the position also heat is transferred from the resistive heater layer 23 to the substance SB with a position dependent delay. Consequently also transfer of the substance SB to the non-planar surface TS1, TS2, is performed with a position dependent delay. Therewith a coverage of the deposited specimen SB of the substance on a non-planar surface can be optimized as exemplified below. In the exemplary application of the improved printing device in FIG. 4A, 4B, 4C the specimen carrier area 264 has a first portion 2641 to be positioned opposite a surface portion TS2 of the target T that is relatively close to the carrier 2. It has a second portion 2642 to be positioned opposite a surface portion TS1 of the target T that is relatively far from the carrier 2 and laterally near the surface portion TS2. A third portion 2643 of the specimen carrier area is to be positioned opposite a surface portion TS1 of the target T that is relatively far from the carrier 2 and laterally more remote from the surface portion TS2 of the target T. In this example a thickness of the structured thermal buffer layer 25 in the second portion 2642 is smaller than a thickness of the structured thermal buffer layer 25 in the first portion 2641 and in the third portion 2643 or is absent.

The effect of the thermal buffer layer 25 structured in this way is illustrated in FIG. 4B and FIG. 4C. As shown in FIG. 4B, with the relatively small thickness of the second portion 2642 of the structured thermal buffer layer 25 it is achieved that central portion SBC of the strip SB is transferred with a lesser delay than the end portions SBL, SBR. Consequently, it can arrive at the target surface portion TS1 before it is slowed down by the end portion TS2. Therewith a coverage of the deposited specimen strip SB of the substance on the non-planar surface is achieved, as shown in FIG. 4C.

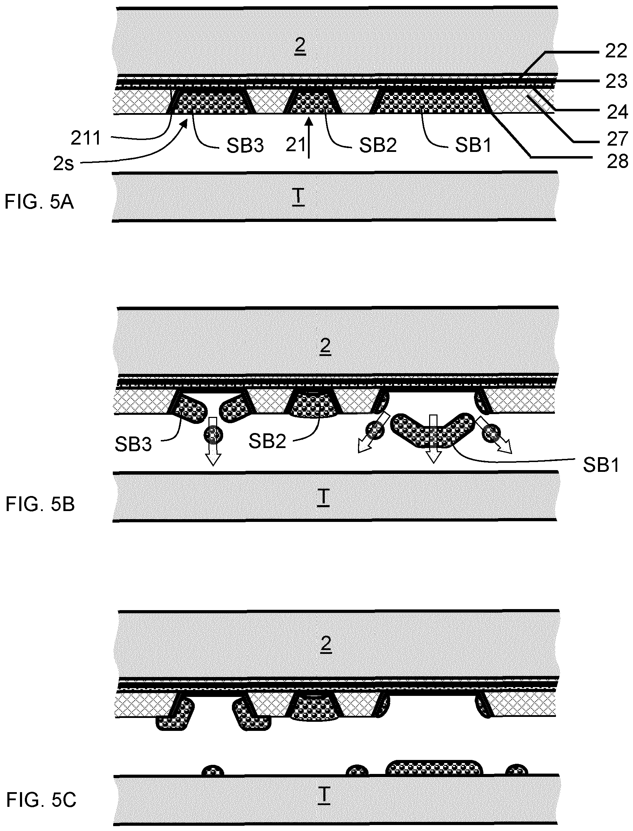

FIG. 5A, 5B, 5C show a further application, performed with a conventional printing device. This example, the carrier 2 is provided at the first main side 21 with at least one recess 211 for accommodating the specimen SB1, SB2, SB3 of the substance to be printed. The recesses 211 are provided in a low thermally conductive coating 27 on the carrier 2. FIG. 5A shows the operational state wherein the recesses 211 have been filled with the substance. In FIG. 5A, the reference numeral 28 indicates a heat spreader layer.

FIG. 5B shows an operational stage wherein the resistive heater layer 23 has heated the carrier surface to vaporize a small layer of the specimen at the side of the carrier surface so as to induce a vapor pressure that causes a transfer of a remainder of said specimen towards the target surface.

Although the heat spreader layer 28 serves to provide for a heat flow towards the side walls of the recesses 211, this involves a delay. Consequently, the transfer of a specimen tends to be initiated while the periphery thereof is still adhered to the side wall of the recess wherein it is accommodated. As can be seen the following phenomena may occur. In this example the relatively large specimen SB1 breaks up in a central portion which is transferred towards the target, two intermediary portions that are also transferred towards the target, in deviating directions, and peripheral portions that remain at the sidewalls of the recess. The specimen SB2 integrally remains within its recess as a result of the adherence to the sidewalls. Finally a central portion of the specimen SB3 is transferred to the target, but central portions thereof remain at the sidewalls of the recess 211 and the surrounding surface of the low thermally conductive coating 27.

Consequently, as shown in FIG. 5C, part of the specimen to be printed is not transferred at all, or only partly or improperly.

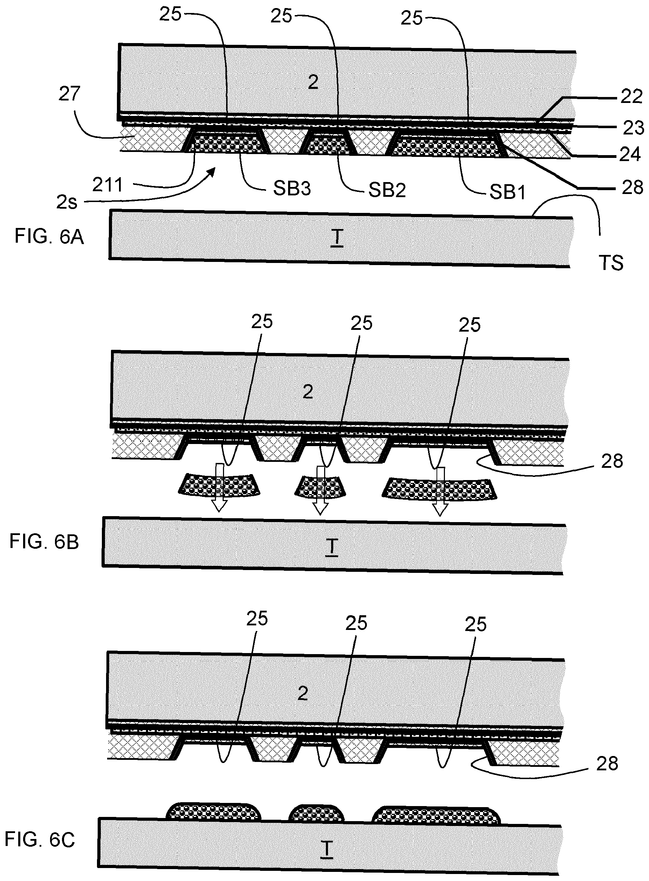

FIG. 6A, 6B, 6C show the same application as described with reference to FIG. 5A, 5B and 5C, now performed with an embodiment of the improved printing device.

As shown in FIG. 6A, 6B, 6C the improved printing device comprises a structured thermal buffer layer 25 having a thickness near a boundary of the recess 211 that is smaller than a thickness of the structured thermal buffer layer 25 in a central portion of the recess 211. More specifically the thickness of the structured thermal buffer layer 25 is different from zero at a bottom of the recess, which is in the central portion, but has zero thickness at the sidewalls of the recess, which are near the boundary.

FIG. 6A shows the operational state wherein the recesses 211 have been filled with specimen SB1, SB2, SB3 of the substance.

FIG. 6B shows an operational stage wherein the resistive heater layer 23 has heated the carrier surface to vaporize a small layer of the specimen at the side of the carrier surface so as to induce a vapor pressure that causes a transfer of a remainder of said specimen towards the target surface. In this operational stage of the improved device, the structured thermal buffer layer 25 delays the heat flux from the resistive heater layer 23 in the bottom of the recess so that the delay is comparable with the delay of the heat flux towards the sidewalls. As a result, the specimen SB1, SB2, SB3 is heated approximately uniformly over its interface that contacts the carrier within the recess 211. Therewith, it is prevented that substance of the specimen SB1, SB2, SB3 remains adhered to the sidewalls of the recess 211.

As shown in FIG. 6C, the specimen SB1, SB2, SB3 therewith are printed on the surface of the target in a manner conformal to their shape defined by the recesses 211 of the carrier.

It is not necessary to completely compensate the delay with which heat is transferred to the sidewalls of the recess. It is even favorable to release the periphery of the substance with a slight delay (0.1 - 0.5 µs). As shown in the example in FIG. 6B, this will deform the substance into a convex shape, which helps preventing bubble entrapment when impacting the target.

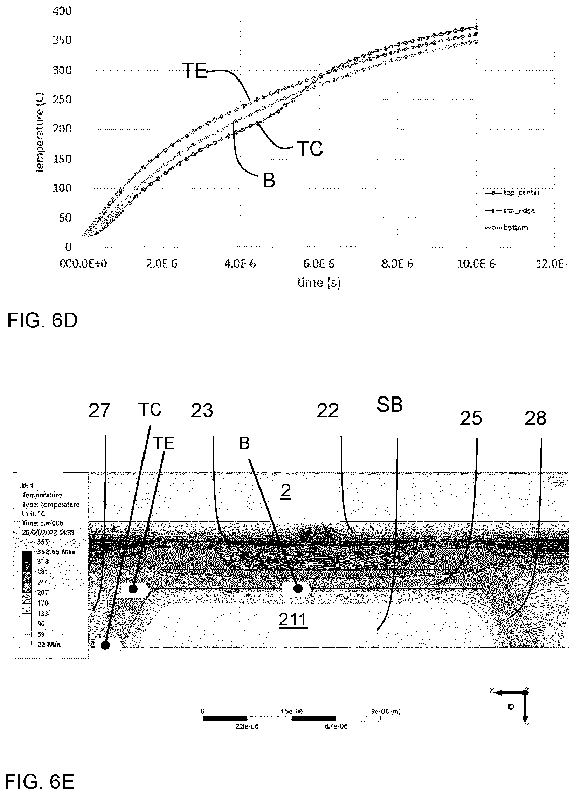

FIG. 6D and 6E shows simulation results.

Therein FIG. 6D shows the temperature as a function of time in three positions of the recess, these are the top-center TC, a top-edge TE and a bottom B referred to in FIG. 6E. FIG. 6E shows a simulated temperature distribution occurring 3µs after the start of a heating pulse.

In this simulation a 1 µm thick heat spreader 28 with a thermal conductivity of 60 W/mK was presumed. The delay td in microseconds occurring in the arrival of the heating pulse at the side walls of the recess 211 relative to the center thereof is indicated for various thicknesses d25 of the structured thermal buffer layer 25 (here presumed to be of SiO2) for a recess 211 having a width of 10 micron (w10) and for a recess 211 having a width of 20 micron (w20). The results are shown in the following table.

| d25 (µm) | td (µs) for w10 | td (µs) for w20 |
|---|---|---|
| 0 | 2.4 | 3.0 |
| 0.5 | 1.2 | 1.8 |
| 1 | 0.8 | 1.0 |
| 2 | -4 | -5 |

The cross-section shows the temperature distribution at a point in time 3 microseconds succeeding the heating pulse generated in the resistive heater layer 23.

As can be seen for example the relative delay td can reduced to 1 microsecond or less by only 1 micrometer of silicon dioxide in the bottom of the recess.

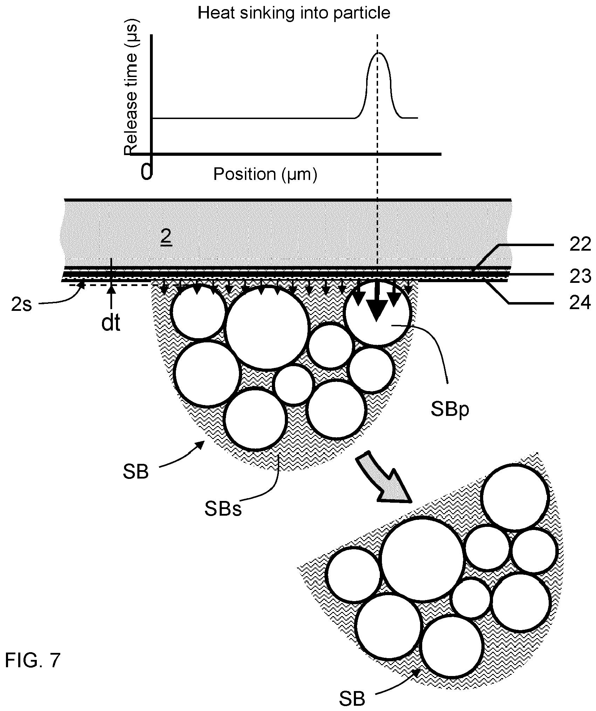

FIG. 7 shows a still further application, performed with a conventional printing device.

In this application the substance SB to be printed comprises particles SBp in a suspension agent SBs. An example thereof is a solder paste, which comprises relatively large metal particles that with a high thermal conductivity suspended in the suspension agent typically having a relatively low thermal conductivity. The thermal penetration depth dt in the suspension agent therewith is typically in the order of a few micron only. However, when such a particle SBp comes in close proximity (<2 µm) of the carrier surface, it will act as a strong heat sink. This is illustrated in the graph above the carrier 2. Due to this heat sinking effect, the temperature rises slower near the metal particle as compared to a portion of the substance SB where no heat sinking occurs. As a result thereof release of the substance SB delayed in the neighborhood of the particles. Typically this heat sinking is asymmetrical, and consequently, the substance will not be transferred in a direction perpendicular away from the carrier and land on the wrong location on the target.

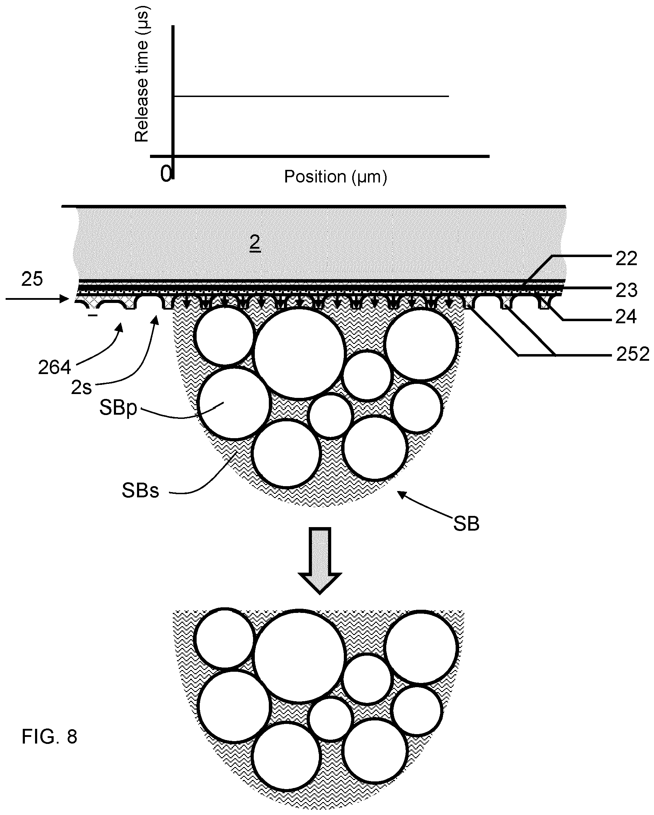

FIG. 8 shows the same application as in FIG. 7, now performed with an embodiment of the improved printing device. As shown therein the structured thermal buffer layer 25 is provided within at least one specimen carrier area (264) with a plurality of micropillars 252. The micropillars have height that is in the same order of magnitude as the thermal penetration depth of the suspension agent or somewhat higher, and at a distance from each other small enough to prevent that the particles SBp can directly touch the surface below the structured thermal buffer layer 25. Therewith uniform heating of the substance SB over its contact surface with the structured thermal buffer layer 25 and therewith also a uniform distribution of the time of release is achieved as shown in the graph above the carrier 2.

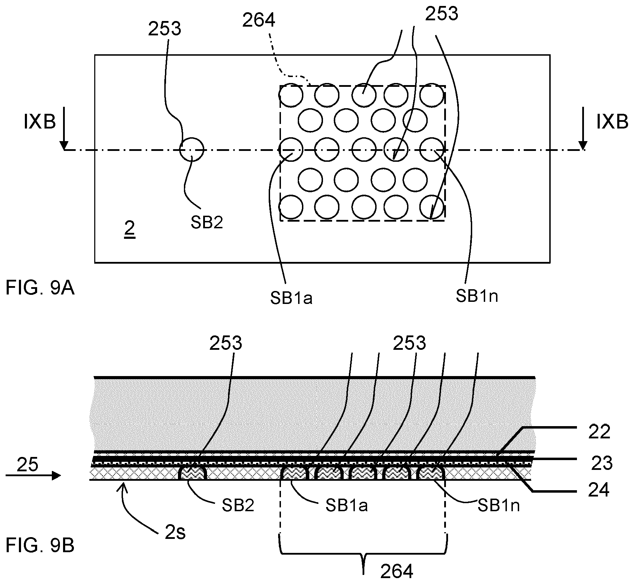

FIG. 9A and 9B illustrate aspects of a further embodiment of the improved printing device. Therein FIG. 9A shows the first main side of a lateral portion of the carrier 2, and FIG. 9B shows a cross-section according to IXB-IXB in FIG. 9A. As shown in FIG. 9A and 9B, the structured thermal buffer layer 25 is provided within at least one specimen carrier area 264 with a plurality of microwells 253 , wherein specimen SB1a, ...,SB1n of the substance to be printed on is distributed over said microwells. The microwells 253 in the specimen carrier area 264 have a diameter less than about 50 micron, and a center to center distance in a range between 1 and 2 times the diameter.

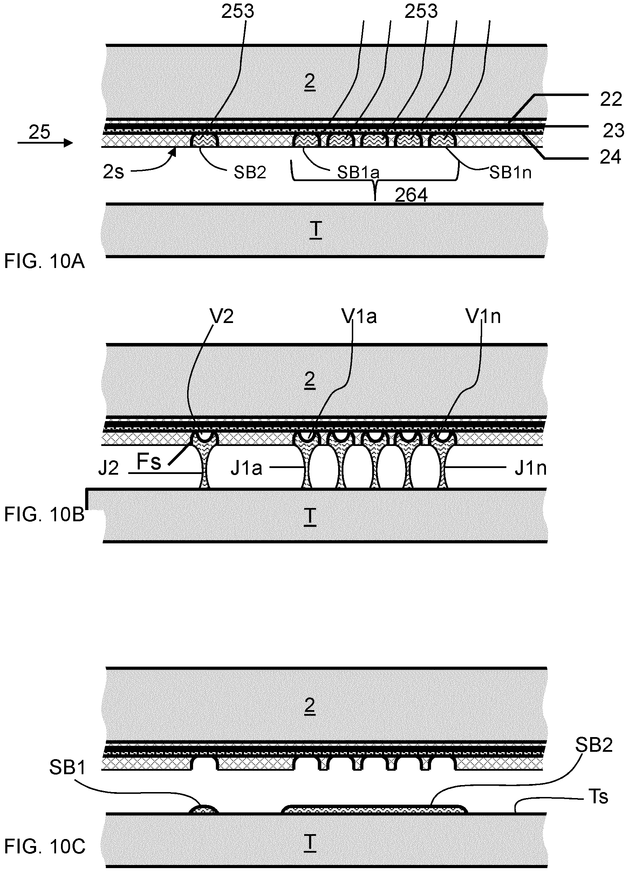

As shown in FIG. 10A - 10C, this further embodiment is particularly suitable for printing low-viscosity substances, i.e. having a viscosity less than 1 Pa*s,

FIG. 10A shows the operational state wherein the microwells 253 have been filled with a low-viscosity substance. In this example the isolated microwell 253 on the left side is filled with a specimen SB2 of a low-viscosity substance and the microwells 253 within the at least one specimen carrier area 264 have been filled with respective specimen SB1a, ..., SB1n, of another low-viscosity substance. In the example shown, the microwells 253 are substantially hemispherical, wherein the microwells 253 abut on the electrical insulating layer 24. In an alternative embodiment, to be used only for printing electrically insulating substances, electrical insulating layer 24 is absent and the microwells 253 directly abut on the resistive heater layer 23. In a further example an electrical insulating layer 24 is absent and the structured thermal buffer layer 25 is of an electrically insulating material and has a non-zero thickness in the bottom of the microwells 253. It is further noted that the microwells may be provided with a shape other than a hemispherical shape

FIG. 10B shows an operational stage wherein the resistive heater layer 23 has heated the carrier surface. As shown therein, a portion of the low-viscosity substance near the bottom part of the micro-well 253 is heated first and vaporizes, while the low-viscosity substance near the side-wall of the micro-well 253, in the absence of a heat-spreader layer, remains fluid and tends to remain within the micro-well by adhesion forces between the substance and the material of the structured thermal buffer layer 25. As a result shear forces Fs occur in the specimen of the low-viscosity substance in a microwell that bring about that the specimen is transferred as a micro-jet towards the target T. For example the specimen SB2 is transferred as a micro-jet J2 and the specimen SB1a, ..., SB1n are transferred as micro-jets J1a,...,J1n.

As shown in FIG. 10C, upon impact with the target surface Ts, the specimen SB1a, ..., SB1n of the low-viscosity substance originating from the specimen carrier area 264 and transferred by the micro-jets J1a,...,J1n can spread and flow together to form a uniform coating SB2.

Although in the embodiment shown, the microwells 253 all abut on the electric insulating layer 24, microwells may have a mutually different depth. For example in some micro-wells the structured thermal buffer layer 25 may have a non-zero thickness at the bottom thereof to provide for a delay of the transfer of the substance therein relative to the transfer from other micro-wells.

FIG. 11A, 11B, 11C show further simulations wherein deformations of a specimen during its transfer are investigated.

The simulation is performed with the following conditions:
Heat flux induced by the electric heater layer: 150 kW/cm².
The substance specified in the simulation has the following properties Density: 2650 kg/m³.
Thermal conductivity: 0.4 W/mK.
Elasticity modulus: 2 MPa
Viscosity: 1 Pa.s.
The substance is presumed to be transferred as a rotationally symmetric specimen with a diameter of 1.2 mm and a maximum height of 100 µm.

The top part of each of the figures 11A, 11B and 11C shows the relative delay in µs (if any) induced by a thermal buffer layer (if any) as a function of the radial position r in µs. The bottom part of these figures shows the simulated shape of the specimen being transferred at subsequent points in time t1-t7. Therein the specimen is shown as a cross-section through its center.

In the situation shown in FIG. 11A, the heat pulse arrives at the full surface below the specimen at the same point in time. Row 0 indicates the cross-section of the specimen when it is still present of the donor plate surface. It can be seen that at the points in time t1-t3 the specimen has assumed a concave shape. This would imply that in this case the specimen would entrap air bubbles in case the print gap between the donor plate surface and the target surface were in a range between about 250 µm and about 750 µm.

In the situation shown in FIG. 11B, the heat pulse arrives at the donor plate surface with a delay that radially increases from 0 µs in the center of the specimen to 5 µs at the edge of the specimen. As shown in the lower part of FIG. 11B, this affects the way in which the shape of the specimen transforms during its transfer. FIG. 11B indicates that there is still a risk that the specimen entraps air bubbles in case it would arrive at the target at point in time t1, t3 or t6.

In the situation shown in FIG. 11C, the heat pulse arrives at the donor plate surface with a delay that radially decreases from 5 µs in the center of the specimen to 0 µs at the edge of the specimen. As shown in the lower part of FIG. 11C, with this delay pattern, oscillations of the specimen are substantially suppressed. Therewith it is rendered possible to select the print gap from a large range while avoiding the risk of bubble entrapment.

In alternative embodiments it can be achieved with thermal buffer layer thickness profile that desired oscillations are induced to achieve a particular desired deposition pattern of the remaining specimen.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A printing device (1) for printing a substance on a target surface (TS) of a target (T), the printing device comprising:
a carrier (2) having at a first main side (21) a carrier surface (2s) for carrying a specimen (SB1, SB2, SB3) of the substance to be printed, and
a heater facility (23) for heating the carrier surface to vaporize a portion of the specimen at the side of the carrier surface and inducing a vapor pressure that causes a transfer of a remainder of said specimen towards the target surface, and
a structured thermal buffer layer (25) that provides for a position dependent delay with which heat is transferred from the heater facility to the carrier surface.

2. The printing device (1) according to claim 1, wherein the heater facility (23) is an electric heater layer (23) for resistively heating the carrier surface.

3. The printing device (1) according to claim 1, wherein the heater facility (23) is a photon radiation source.

4. The printing device according to any of the preceding claims, wherein the carrier surface comprises at least a first specimen carrier area (261) and a second specimen carrier area (262) for respectively carrying a first and a second specimen (SB1, SB2) of the substance to be printed wherein a thickness of the thermal buffer layer within the one of the at least a first specimen carrier area (261) and a second specimen carrier area (262) having the largest size is greater than a thickness of the thermal buffer layer within the one of the at least a first specimen carrier area (261) and a second specimen carrier area (262) having the smallest size.

5. The printing device according to claim 1, 2 or 3, having a specimen carrier area (264) configured for carrying a specimen (SB) of the substance to be transferred to a target (T), and wherein the structured thermal buffer layer (25) has a thickness profile within the specimen carrier area (264) to control a dynamic behavior of the remainder of the specimen during its transfer to the target surface.

6. The printing device according to claim 5, wherein the specimen carrier area (264) is configured for carrying a specimen (SB) of the substance to be transferred to a target (T) with a non-planar surface (TS1, TS2), and wherein the structured thermal buffer layer (25) has a varying thickness within the specimen carrier area (264) to provide for a position dependent delay with which the specimen is transferred to the non-planar surface (TS1, TS2) to optimize a coverage of the deposited specimen (SB) of the substance on said non-planar surface (TS1, TS2).

7. The printing device according to claim 6, wherein the specimen carrier area (264) has a first portion (2641) to be positioned opposite a surface portion (TS2) of the target (T) that is relatively close to the carrier (2), a second portion (2642) to be positioned opposite a surface portion (TS1) of the target (T) that is relatively far from the carrier (2) and laterally near the surface portion (TS2) of the target (T) and a third portion (2643) to be positioned opposite a surface portion (TS1) of the target (T) that is relatively far from the carrier (2) and laterally more remote from the surface portion (TS2) of the target (T), and wherein a thickness of the structured thermal buffer layer (25) in the second portion (2642) is smaller than a thickness of the structured thermal buffer layer (25) in the first portion (2641) and the third portion (2643) or is absent.

8. The printing device according to claim 5, wherein the thermal buffer layer has a thickness that decreases in a radially outward direction from a central position of the specimen carrier area.

9. The printing device according to claim 1, 2 or 3, wherein the carrier (2) is provided at the first main side (21) with at least one recess (211) for accommodating a specimen (SB 1) of the substance to be printed and wherein a thickness of the structured thermal buffer layer (25) near a boundary of the recess is smaller than a thickness of the structured thermal buffer layer (25) in a central portion of the recess.

10. The printing device according to claim 1, 2 or 3, wherein the structured thermal buffer layer (25) is provided within at least one specimen carrier area (264) with a plurality of microwells, wherein a specimen of the substance to be printed on is distributed over said microwells.

11. The printing device according to claim 10, wherein microwells provided in the structured thermal buffer layer (25) have a mutually different depth.

12. The printing device according to claim 1, 2 or 3, wherein the structured thermal buffer layer (25) is provided within at least one specimen carrier area (264) with a plurality of micropillars.

13. Method for printing a substance on a target surface (TS) of a target (T), the method comprising:
providing a carrier (2) having at a first main side (21) a carrier surface (2s) for carrying a specimen (SB1, SB2, SB3) of the substance to be printed;
providing a heater facility (23) for heating the carrier surface;
providing a structured thermal buffer layer (25) between the resistive heater layer (23) and the carrier surface (2s);
activating the heater facility;
with the structured thermal buffer layer (25) transferring heat from the heater facility with a position dependent delay to the carrier surface;
wherein heat transferred to the carrier surface causes a portion of the specimen in contact with the carrier surface to vaporize with the position dependent delay determined by the structured thermal buffer layer (25) and therewith inducing a vapor pressure that causes a transfer of a remainder of said specimen towards the target surface.

14. The method of claim 13, comprising providing the carrier surface with at least a first specimen carrier area (261) and a second specimen carrier area (262) for respectively carrying a first and a second specimen (SB1, SB2) of the substance to be printed, and providing the thermal buffer layer with a thickness within the one of the at least a first specimen carrier area (261) and a second specimen carrier area (262) having the largest size that is greater than a thickness of the thermal buffer layer within the one of the at least a first specimen carrier area (261) and a second specimen carrier area (262) having the smallest size.

15. The method of claim 13, comprising providing the structured thermal buffer layer (25) with a varying thickness to provide for a position dependent delay with which the specimen is transferred to the target (T) to optimize a coverage of the deposited specimen (SB) of the substance on a non-planar surface (TS1, TS2) of the target.

16. The method of claim 13, comprising providing the carrier (2) at the first main side (21) with at least one recess (211) for accommodating a specimen (SB 1) of the substance to be printed and providing the structured thermal buffer layer (25) with a thickness near a boundary of the recess that is smaller than a thickness of the structured thermal buffer layer (25) in a central portion of the recess.

17. The method according to claim 13, comprising providing the structured thermal buffer layer (25) within at least one specimen carrier area (264) with a plurality of microwells, wherein a specimen of the substance to be printed is distributed over said microwells.

18. The method according to claim 13, comprising providing the structured thermal buffer layer (25) within at least one specimen carrier area (264) with a plurality of micropillars.
